Europäisches Patentamt

European Patent Office

Office européen des brevets

(11) Veröffentlichungsnummer: **0 268 244 B1**

# (12) EUROPÄISCHE PATENTSCHRIFT

(45) Veröffentlichungstag der Patentschrift: **15.05.91**

(51) Int. Cl.⁵: **F16P 3/00**

(21) Anmeldenummer: **87116884.5**

(22) Anmeldetag: **16.11.87**

---

(54) Sicherheitseinrichtung.

---

(30) Priorität: **20.11.86 DE 3639628**
**17.12.86 DE 3643060**

(43) Veröffentlichungstag der Anmeldung:
**25.05.88 Patentblatt 88/21**

(45) Bekanntmachung des Hinweises auf die
Patenterteilung:
**15.05.91 Patentblatt 91/20**

(84) Benannte Vertragsstaaten:
**AT BE CH DE ES FR GB GR IT LI LU NL SE**

(56) Entgegenhaltungen:

CH-A- 584 981     DE-U- 8 611 018
DE-U- 8 613 771     DE-U- 8 631 049
DE-U- 8 633 717     DE-U- 8 707 316
FR-A- 1 564 099     GB-A- 700 751

SOVIET INVENTIONS ILLUSTRATED, 29. April
1981, M 23, Ref. Nr. 20739D/12, Derwent Publications Ltd., London, GB & SU-A-710548
(KUIB POWER CONS. ORG.) 25-01-1980

SOVIET INVENTIONS ILLUSTRATED, 28. November 1979, M. 23, Ref. Nr. 76741B/42, Derwent Publications Ltd., London, GB & SU-
A-644489 (KUIB ORGENEGOSTROI)
30-01-1979

(73) Patentinhaber: **Ernst Peiniger GmbH Unternehmen für Bautenschutz
Am Funkturm 2
W-4300 Essen 1(DE)**

(72) Erfinder: **Genuit, Klaus, Dr.-Ing.
Wildbacher Mühle 77
W-5100 Aachen(DE)**
Erfinder: **Cardinal, Joachim
Hebborner Kirchweg 101
W-5060 Berg.-Gladbach 2(DE)**
Erfinder: **Glaeser, Karl Christian
Am Arenzberg 24
W-5090 Leverkusen 3(DE)**
Erfinder: **Tilmans, Heinz
Repinghofener Strasse 8
W-5093 Burscheid(DE)**
Erfinder: **Buhr, Gerhard
Karl-Jaspers-Strasse 101
W-5090 Leverkusen 3(DE)**
Erfinder: **Lohmüller, Detlef, Dipl.-Ing.
Rilke Strasse 90
W-5300 Bonn 3(DE)**

---

(74) Vertreter: **Gesthuysen, Hans Dieter, Dipl.-Ing.
et al
Patentanwälte Gesthuysen + von Rohr
Huyssenallee 15 Postfach 10 13 33
W-4300 Essen 1(DE)**

## Beschreibung

Die Erfindung betrifft eine Sicherheitseinrichtung nach dem Oberbegriff von Anspruch 1.

Sicherheitseinrichtungen sind für alle Arten von von einer Bedienungsperson zu handhabenden Geräten empfehlenswert, um eine Bedienungsperson gegen Unfälle zu schützen bzw. eine unkontrollierte Funktion des von der Bedienungsperson zu handhabenden Geräts zu vermeiden. Eine solche Sicherheitseinrichtung ist beispielsweise für eine von einer Bedienungsperson geführte Schleifmaschine. Fräsmaschine od. dgl. ebenso empfehlenswert wie für ein Wasserlöschgerät oder Schaumlöschgerät einer Feuerbekämpfungsanlage, einen Schweißbrenner, einen Spritzkopf für Lackierarbeiten oder Spritzmetallisierung usw.. Von besonderer Bedeutung ist eine solche Sicherheitseinrichtung für ein Strahgerät einer Strahlanlage zum Druckmittelstrahlen - Trockenstrahlen, Feuchtstrahlen, Naßstrahlen - wo eine derartige, gewissermaßen als Totmannschaltung wirkende Sicherheitseinrichtung durch Sicherheitsvorschriften gefordert wird.

Bei der bekannten Sicherheitseinrichtung (DE-U 86 13 771), die für ein Strahlgerät einer Strahlanlage bestimmt und geeignet ist, bei der das von der Bedienungsperson zu handhabende Strahlgerät über eine Versorgungsleitung für ein Strahlmittel, dort von Druckluft gefördertes körniges Strahlmittel, an eine Strahlmittelquelle angeschlossen ist, wird die Funktion des Strahlgeräts von der Strahlmittelquelle aus gesteuert. An der Strahlmittelquelle ist eine Steuereinrichtung vorgesehen, mit der die Zufuhr von Strahlmittel gesteuert werden kann. Die Steuereinrichtung wird von einem Betätigungssensor her beeinflußt, der an einem Handgriff des Strahlgeräts angeordnet ist. Der Betätigungssensor steht über ein Kabel mit der Steuereinrichtung in Verbindung. Bei Wegfall der Beeinflussung des Betätigungssensors durch die Bedienungsperson wird das Strahlgerät abgeschaltet.

Der Betätigungssensor der bekannten Sicherheitseinrichtung ist als elektronischer, berührungslos betätigbarer, nur von einem speziellen Beeinflussungselement, insbesondere einer Folie beeinflußbarer Annäherungssensor ausgeführt. Neben dem Betätigungssensor ist dem Strahlgerät außerdem noch eine Normalbetätigungseinheit für eine Fernbedienung des Strahlgeräts zugeordnet. Diese Normalbetätigungseinheit weist eine Mehrzahl von Betätigungselementen für unterschiedliche Funktionen auf.

Bei der bekannten Sicherheitseinrichtung ist der Betätigungssensor erheblich schwieriger zu überbrücken als beispielsweise ein mechanischer Handhebel einer Totmannschaltung od. dgl.. Gleichwohl ist eine Überbrückung nicht unmöglich.

Auf dem Gebiet der Schweißtechnik ist es für sich bekannt, einen elektrischen Stromkreis über zwei Kontaktelektroden und den metallischen Handgriff der Schweißelektrode zu schließen. Die Kontaktelektroden sind in der Grifffläche eines Schweißer-Schutzhandschuhs angeordnet, so daß der elektrische Kontakt und damit die Führung des Schweißstromes unterbrochen wird, wenn der Schweißer den Handgriff der Schweißelektrode losläßt. Dieser Schweißer-Schutzhandschuh nur dann sinnvoll einsetzbar, wenn wie in der in SU-A-710 548 beschriebenen Anwendung mit elektrischem Strom als Arbeitsmittel gearbeitet wird.

Der Erfindung liegt nun die Aufgabe zugrunde, die eingangs erläuterte, bekannte Sicherheitseinrichtung für das Strahlgerät einer Strahlanlage so zu verbessern, daß eine Überbrückung des Betätigungssensors praktisch unmöglich ist.

Die zuvor aufgezeigte Aufgabe ist bei einer Sicherheitseinrichtung mit den Merkmalen des Oberbegriffs von Anspruch 1 durch die Merkmale des kennzeichnenden Teils von Anspruch 1 gelöst. Dadurch, daß der Betätigungssensor an der Hand der Bedienungsperson angebracht ist, ist eine Überbrückung der Sicherheitseinrichtung bzw. des Betätigungssensors überhaupt nicht möglich, da das Strahlgerät selbst nur passiv ist. Ohne den der Hand der Betätigungsperson zugeordneten Betätigungssensor ist eine Funktion des Strahlgeräts systematisch ausgeschlossen.

Es gibt nun viele Möglichkeiten, die erfindungsgemäße Sicherheitseinrichtung in zweckmäßiger Weise auszugestalten und weiterzubilden. Das wird in Verbindung mit der nachfolgenden Erläuterung eines bevorzugten Ausführungsbeispiel einer mit einer erfindungsgemäßen Sicherheitseinrichtung ausgestatteten Strahlanlage anhand der Zeichnung erläutert. In der Zeichnung zeigt

Fig. 1    in schematischer Darstellung ein Ausführungsbeispiel einer Strahlanlage zum Druckluftstrahlen und

Fig. 2    in schematischer Darstellung den Bereich eines von einer Bedienungsperson zu handhabenden Gerätes einer Strahlanlage gemäß Fig. 1.

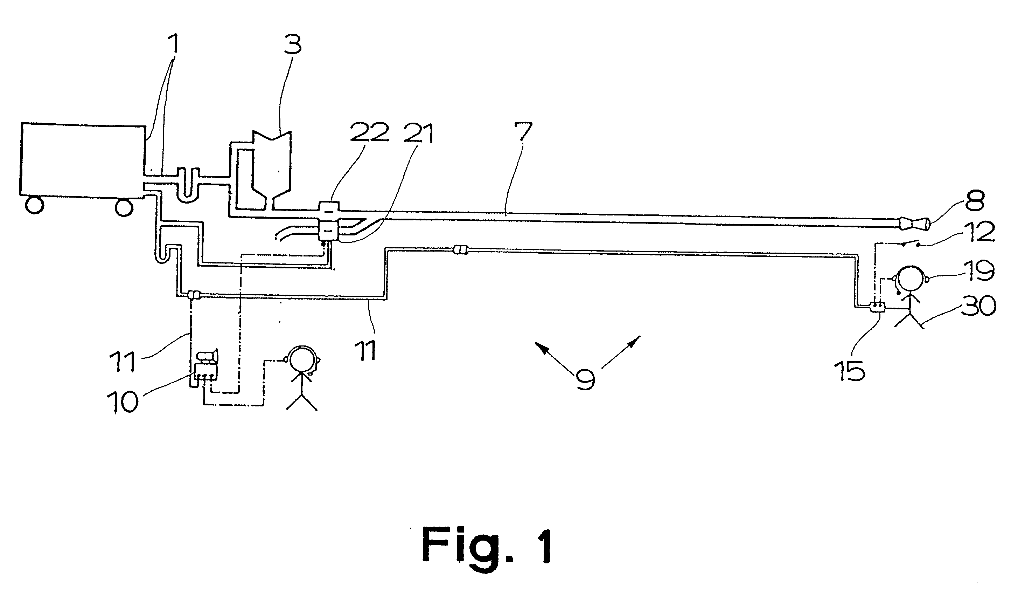

Die in Fig. 1 dargestellte Strahlanlage zeigt eine Druckluftleitung 1, die an eine Versorgungsmittelquelle 3, hier in der Form eines üblichen Strahlmittelvorratsbehälters, angeschlossen ist. Von einer Anschlußeinrichtung des Strahlmittelvorratsbehälters 3 aus führt eine Versorgungsleitung 7 zu einem Strahlgerät 8, das von einer Bedienungsperson 30 zu handhaben ist. Im hier dargestellten Ausführungsbeispiel handelt es sich bei der Versorgungsleitung 7 um eine Druckluft/Strahlmittelleitung und beim Gerät 8 um ein Strahlgerät. Im folgenden wird das in den Ansprüchen als Strahlgerät 8 bezeichnete Gerät einfach als Gerät 8 bezeichnet.

Die in Fig. 1 dargestellte Strahlanlage ist mit einer Sicherheitseinrichtung 9 für das von einer Bedienungsperson zu handhabende Gerät 8 ausgestattet, die eine Steuereinrichtung 10 zur Steuerung der Funktion des Geräts 8 und einen am Gerät 8 zugeordneten, von einer Bedienungsperson zu beeinflussenden, mit der Steuereinrichtung 10 über ein Kabel 11 verbundenen Betätigungssensor 12 aufweist. Bei Wegfall der Beeinflussung des Betätigungssensors 12 durch die Bedienungsperson 30 ist das Gerät 8 abschaltbar.

Der Betätigungssensor 12 ist als elektronischer, berührungslos betätigbarer Annäherungssensor ausgeführt. Ganz allgemein kann ein solcher Annäherungssensor induktiv, kapazitiv, optisch, thermisch oder auch akustisch beeinflußbar sein, was später noch genauer erläutert werden wird.

In Fig. 1 ist noch angedeutet, daß neben dem Betätigungssensor 12 eine Normalbetätigungseinheit 15 für eine Fernbedienung des Geräts 8 vorgesehen ist. Eine solche Normalbetätigungseinheit 15 dient der normalen Betätigung des Geräts 8, wohingegen der Betätigungssensor 12 eher der Notfallbetätigung, insbesondere im Rahmen einer Totmannschaltung dient.

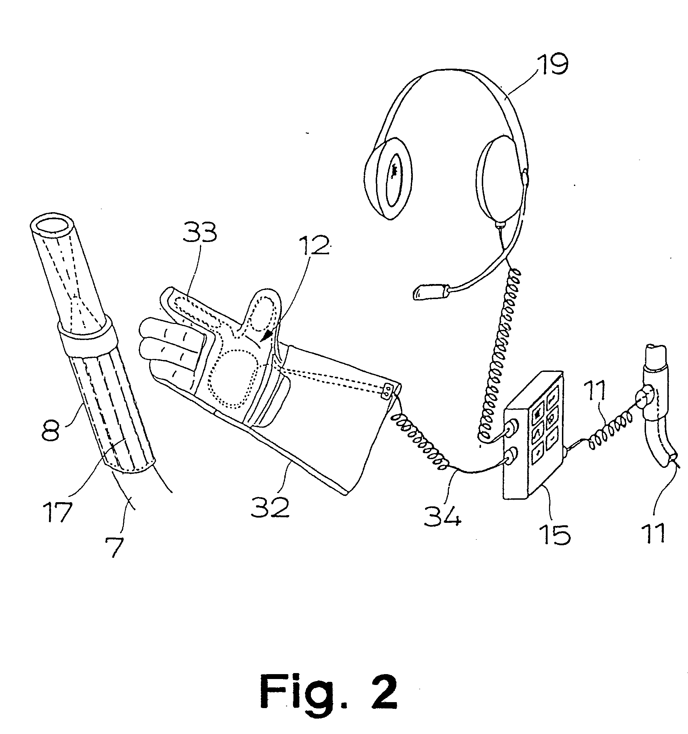

Die Fig. 1 und 2 lassen weiter noch erkennen, daß das Gerät 8 einen von einer Hand der Bedienungsperson 30 zu erfassenden oder umfassenden Handgriff 17 aufweist.

Bei dem in Fig. 1 und 2 dargestellten Ausführungsbeispiel einer Strahlanlage als Beispiel einer Anlage im allgemeinen, ist nun der Betätigungssensor 12, hier genau gesagt ein Indikatorelement des Betätigungssensors 12, an der Hand der Bedienungsperson 30 angebracht. Im hier dargestellten und bevorzugten Ausführungsbeispiel ist das Indikatorelement des Betätigungssensors 12 in einen Schutzhandschuh 32 für die Hand der Bedienungsperson 30 integriert. Als Indikatorelement des Betätigungssensors 12 dient im in Fig. 2 besonders deutlich dargestellten Ausführungsbeispiel eine Luftspule 33, die hier in die Griffläche des Schutzhandschuhs 32 integriert ist. Die Luftspule 33 ist im hier dargestellten Ausführungsbeispiel über ein Anschlußkabel 34 mit einer Zentralelektronik bzw. einer Ansteuerelektronik verbunden, wozu später noch mehr erläutert werden wird. Im Handwurzelbereich des Schutzhandschuhs 32 sind Steck- bzw. Knopfkontakte zum Anschluß des Anschlußkabels 34 angedeutet. Im hier dargestellten und bevorzugten Ausführungsbeispiel ist die Luftspule 33 flächig über die Griffläche des Schutzhandschuhs 32 und in den Zeigefinger und den Daumen hinein verteilt. Es gilt, daß es insbesondere zweckmäßig ist, wenn das Indikatorelement in der Griffläche des Schutzhandschuhs 32 an einer weitgehend bewegungsfreien Stelle, insbesondere zwischen Daumen und Zeigefinger angeordnet ist. Das Indikatorelement muß also nicht zwingend die in Fig. 2 konkret dargestellte großflächige Ausdehnung haben. Damit ist gleichzeitig ein weiterer Sicherheitseffekt erzielt, als nämlich das Umgreifen des Geräts 8 mit der bloßen Hand nicht zur Beeinflussung des Betätigungssensors 12 führt, eine Bedienungsperson 30 also gezwungen ist, bei der Arbeit den Schutzhandschuh 32 zu tragen. Dadurch ergibt sich der Vorteil, daß eine Überbrückung des Betätigungssensors 12 und eine Ausschaltung des Sicherheitseffekts der erfindungsgemäßen Sicherheitseinrichtung 9 für eine normale Bedienungsperson 30 extrem schwierig wird. Da der Betätigungssensor 12 dem Schutzhandschuh 32, d. h. der Bedienungsperson 30 zugeordnet ist, ist eine Überbrückung der Sicherheitseinrichtung 9 nicht möglich, da eben das Gerät 8 selbst nur passiv ist. Ist der Betätigungssensor 12, insbesondere dessen Indikatorelement, nur durch ein besonderes Beeinflussungselement beeinflußbar, so empfiehlt es sich natürlich im vorliegenden Ausführungsbeispiel, das Beeinflussungselement am Gerät 8 anzubringen, insbesondere flächig in die Oberfläche des Geräts 8 zu integrieren. Das ist in Fig. 2 nur angedeutet. Im einzelnen gilt, daß beispielsweise eine das Beeinflussungselement bildende Folie um eine Düse, einen Düsenhalter oder die Versorgungsleitung 7 selbst gewickelt bzw. geklebt werden kann. Es gilt aber auch, daß das Beeinflussungselement beispielweise in einen Gummischlauch integriert, insbesondere einvulkanisiert sein kann, der an der passenden Stelle am Gerät 8 angebracht wird. Besonders empfiehlt es sich jedenfalls, das Beeinflussungselement in den Handgriff 17, vorzugsweise natürlich in die Griffläche des Handgriffs 17, zu integrieren.

Zuvor ist schon einmal kurz angesprochen worden, daß der erfindungsgemäß vorgesehene elektronische, vorzugsweise berührungslos betätigbare Annäherungsschalter als Betätigungssensor durch induktive, kapazitive, optische, thermische oder ähnliche Beeinflussung durch die Bedienungsperson bedienbar ist. Neben der zuvor konkret behandelten Ausgestaltung als induktiver Annäherungsschalter sollen noch verschiedene weitere Ausführungsformen erläutert werden, die in den Figuren nicht dargestellt sind.

Zunächst kann es sich empfehlen, den Betätigungssensor als kapazitiven Annäherungssensor auszuführen. Die Hand der Bedienungsperson könnte dann beispielsweise die Beeinflussung der Ansprechkapazität des kapazitiven Annäherungssensors bewirken.

Eine weitere Alternative besteht auch darin, daß der Betätigungssensor als magnetoelastisch arbeitender Sensor ausgeführt ist. Beispielsweise könnte die magnetoelastische Wirkung eines solchen Sensors beim Umgreifen eines Handgriffs und der damit verbundenen Änderung der mechanischen Belastung eines Arbeitshandschuhs der Bedienungsperson genutzt werden.

In ähnlicher Weise wie ein magnetoelastisch arbeitender Sensor könnte auch ein piezoelektrisch arbeitender Sensor vorgesehen sein. Hier würde dann mechanische Arbeit in elektrische Spannung umgesetzt.

Nach einer weiteren Alternative könnte der Betätigungssensor auch als Dehnungsmeßstreifensensor, insbesondere mit mindestens einem Halbleiter-Dehnungsmeßstreifen, ausgeführt sein. Derartige Dehnungsmeßstreifensensoren sind, insbesondere mit moderner Halbleitertechnik, kostengünstig und zweckmäßig einsetzbar.

Von besondere Bedeutung ist eine weitere Lehre der Erfindung, die dadurch gekennzeichnet ist, daß der Betätigungssensor als Schallsensor, vorzugsweise als Körperschallsensor, insbesondere als Körperschallsensor, ausgeführt ist. Wegen der Störanfälligkeit eines auf Luftschall ansprechenden Schallsensors ist hier in besonders bevorzugter Weise ein Körperschallsensor vorgesehen. Häufig wird es sich dabei um ein speziell auf Körperschall und Körperschallmessung abgestimmtes Mikrofon handeln. Derartige Sensoren sind aus der Fachliteratur bekannt. Das aus dem Gerät austretende Versorgungsmittel, insbesondere ein von Tragluft gefördertes Strahlmittel einer Strahlanlage, erzeugt hochfrequente Schwingungen im Gerät, insbesondere im Düsenkörper des Strahlgeräts. Ist nun beispielsweise ein Körperschallmikrofon in einen Arbeitshandschuh einer Bedienungsperson integriert und an die Steuereinrichtung angeschlossen, so registriert dieses Körperschallmikrofon dann und nur dann den Körperschall im Düsenkörper, wenn der Arbeitshandschuh sich eng um den Handgriff des Düsenkörpers legt. Diese Technik vermeidet die Notwendigkeit, das Gerät selbst in irgendeiner Weise zu präparieren.

Die einzige Möglichkeit, den zuvor erläuterten Betätigungssensor in Form eines Schallsensors, insbesondere eines Körperschallsensors, zu umgehen, besteht darin, ihn mit den Körperschallfrequenzen zu beaufschlagen, die im Betrieb des Gerätes selbst auftreten. Um hier eine Sicherung gegen Fremdeinflüsse in besonderem Maße zu verwirklichen empfiehlt es sich, daß die Steuereinrichtung mindestens ein dem Schallsensor zugeordnetes Frequenzfilter aufweist. Ein Frequenzfilter in der Steuereinrichtung kann z. B. als Tiefpaß, Hochpaß oder Bandpaß ausgeführt sein. Es ist auch möglich, mehrere Frequenzfilter parallel zu schalten, um unterschiedliche Frequenzen, die üblicherweise beim Betrieb des Gerätes auftreten, selektiv feststellen zu können. Auch bestimmte Frequenzbereiche lassen sich mit derartigen Frequenzfiltern herausfiltern (Soll-Schall).

Bei der zuvor erläuterten Sicherheitseinrichtung mit Schallsensor wird nicht nur überprüft, daß die Bedienungsperson den Betätigungssensor tatsächlich beeinflußt, sondern es wird gleichzeitig auch noch festgestellt, ob das Gerät in Betrieb ist oder nicht. Das ist zwar vorteilhaft, führt aber dazu, daß beim Anlaufen des Gerätes, also wenn noch kein Schall bzw. Körperschall vorliegt, eine besondere Maßnahme getroffen werden muß. Hier empfiehlt es sich, daß die Steuereinrichtung einen Überbrückungsschalter aufweist und beim Anlaufen des von der Bedienungsperson zu handhabenden Geräts der Betätigungssensor bis zum Auftreten des entsprechenden Soll-Schalls überbrückbar ist. Es kann schaltungstechnisch vorgesehen sein, daß der Überbrückungsschalter in der Steuereinrichtung automatisch geöffnet wird, sobald vom Betätigungssensor ein Sollsignal, das die Beeinflussung durch die Bedienungsperson und die Funktion des Geräts anzeigt, abgegeben worden ist.

Nicht dargestellt ist in den Figuren, daß dem Betätigungssensor eine Verzögerungsschaltung zugeordnet sein kann, wenn dies vom Anwendungsfall her zweckmäßig erscheint. Nicht erkennbar ist in den Figuren auch, daß der Betätigungssensor, wie schon angesprochen, als nur von einem speziellen Beeinflussungselement, insbesondere einer Folie, vorzugsweise aus Aluminium, Kupfer, einem weichmagnetischen Werkstoff hoher Anfangspermeabilität wie Mumetall, od. dgl. beeinflußbarer Annäherungsschalter ausgeführt sein kann. Mumetall, bzw. Werkstoffe mit hoher Anfangspermeabilität, wie sie beispielsweise zur Verwendung für magnetische Abschirmungen bekannt sind, eignen sich hier in besonderem Maße, da so der Betätigungssensor von Metallen wie Stahl, Aluminium, Zink, Kupfer oder ähnlichem nicht beeinflußt werden kann. Versehentliche Beeinflussungen können also hier sicher verhindert werden.

## Ansprüche

1. Sicherheitseinrichtung (9) für ein von einer Bedienungsperson (30) zu handhabendes Strahlgerät (8) einer Strahlanlage zum Druckmittelstrahlen, wobei das von der Bedienungsperson (30) zu handhabende Strahlgerät (8) über eine Versorgungsleitung (1) für ein Strahlmittel an eine Strahlmittelquelle (3) angeschlossen ist und einen von einer Hand der Bedienungsperson (30) zu erfassenden oder umfassenden Handgriff (17) aufweist, mit einer Steuereinrichtung (10) zur Steuerung der Funktion des Strahlgeräts (8) und mit einem am Strahlgerät (8) angeordneten, von einer Bedienungsperson (30) zu beeinflussenden, mit der Steuereinrichtung (10) verbundenen Betätigungssensor (12), wobei der Betätigungssensor (12) als elektronischer Annäherungsensor ausgeführt ist und wobei bei Wegfall der Beeinflussung des Betätigungssensors (12) durch die Bedienungsperson (30) das Strahlgerät (8) automatisch abgeschaltet wird, **dadurch gekennzeichnet, daß** der Betätigungssensor (12), zumindest ein Indikatorelement des Betätigungssensors (12), an der Hand der Bedienungsperson (30) angebracht ist.

2. Sicherheitseinrichtung nach Anspruch 1, dadurch gekennzeichnet, daß der Betätigungssensor (12), zumindest ein Indikatorelement des Betätigungssensors (12), in einem Schutzhandschuh (32) für die Hand der Bedienungsperson (30) integriert ist.

3. Sicherheitseinrichtung nach Anspruch 2, dadurch gekennzeichnet, daß als Indikatorelement des Betätigungssensors (12) eine Induktionsschleife bzw. eine Luftspule (33) in die Grifffläche des Schutzhandschuhs (32) integriert ist.

4. Sicherheitseinrichtung nach Anspruch 2 oder 3, dadurch gekennzeichnet, daß das Indikatorelement in der Grifffläche des Schutzhandschuhs (32) an einer weitgehend bewegungsfreien Stelle, insbesondere zwischen Daumen und Zeigefinger, angeordnet ist.

5. Sicherheitseinrichtung nach einem der Ansprüche 1 bis 4, wobei der Betätigungssensor (12) als nur von einem speziellen Beeinflussungselement insbesondere einer Folie, vorzugsweise aus Aluminium, Kupfer, einem weichmagnetischen Werkstoff hoher Anfangspermeabilität wie Mumetall, od. dgl. berührungslos beeinflussbarer Annäherungsensor ausgeführt ist, dadurch gekennzeichnet, daß das Beeinflussungselement für den Betätigungssensor (12) am Gerät (8) angebracht, insbesondere flächig in die Oberfläche des Gerätes (8) integriert ist.

6. Sicherheitseinrichtung nach Anspruch 5, dadurch gekennzeichnet, daß das Beeinflussungselement in den Handgriff (17), vorzugsweise in die Grifffläche des Handgriffs (17), integriert ist.

7. Sicherheitseinrichtung nach einem der Ansprüche 1 bis 4, dadurch gekennzeichnet, daß der Betätigungssensor als Schallsensor, vorzugsweise als Körperschallsensor, insbesondere als Körperschallmikrofon, ausgeführt ist.

8. Sicherheitseinrichtung nach Anspruch 7, dadurch gekennzeichnet, daß die Steuereinrichtung mindestens ein dem Schallsensor, insbesondere dem Körperschallmikrofon, zugeordnetes Frequenzfilter aufweist.

9. Sicherheitseinrichtung nach Anspruch 7 oder 8, dadurch gekennzeichnet, daß die Steuereinrichtung einen Überbrückungsschalter aufweist und beim Anlaufen des von der Bedienungsperson zu handhabenden Geräts der Betätigungssensor bis zum Auftreten von Schall, vorzugsweise von Körperschall einer bestimmten Frequenz, eines bestimmten Frequenzbereichs od. dgl. überbrückbar ist.

## Claims

1. Safety device (9) for a blasting apparatus (8) of a blasting unit for pressure blasting, said apparatus (8) to be used by an operator (30), and being connected to a blasting supply (3) via a supply line (1), and comprising a handgrip (17) to be grasped by the hand of the operator (30), comprising a control device (10) for control of the operation of the apparatus (8) and an operating sensor (12) disposed on the apparatus (8), said operating sensor (12) being actuated by the operator (30), being constructed as electronic proximity sensor, and being connected to the control device (10),
said apparatus (8) being automatically switched off as the operator's (30) action on the operating sensor (12) stops, **characterized in that**
the operating sensor (12), at least an indicator element of the operating sensor (12), is disposed on the hand of the operator (30).

2. Safety device (9) according to claim 1, characterized in that the operating sensor (12), at least an indicator element of the operating sensor (12) is integrated into a protective glove (32) for the hand of the operator (30).

3. Safety device (9) according to claim 2, characterized in that an induction loop or an air coil (33) as indicator element of the operating sensor (12) is integrated into the palm of the protective glove (32).

4. Safety device (9) according to claim 2 or claim 3, characterized in that the indicator element in the palm of the protective glove (32) is disposed at a location as free as possible of movement, particularly between the thumb and the index finger.

5. Safety device (9) according to any of claims 1 through 4, wherein the operating sensor (12) is an electronic proximity sensor which may be actuated only by a special actuation element, particularly a foil, preferably of aluminum, copper, a material of low magnetic retentivity with high initual permeability, such as mumetal or the like, characterized in that the actuating element for the operating sensor (12) is disposed on the apparatus (8), in particular is integrated flat into the surface of the apparatus (8).

6. Safety device (9) according to claim 5, characterized in that the actuating element is integrated into the handgrip (17), preferably into the gripping surface of the handgrip (17).

7. Safety device (9) according to any of claims 1 through 4, characterized in that the operating sensor is a sound sensor, preferably for structureborne sound, preferably in the form of a structure-borne sound microphone.

8. Safety device (9) according to claim 7, characterized in that the control device comprises at least one frequency filter associated with the sound sensor, in particular the structure-borne sound microphone.

9. Safety device (9) according to claim 7 or 8, characterized in that the control device is equipped with a bypassing switch permitting the operating sensor to be bypassed during startup of the apparatus until sound, particularly structure-borne sound of a specific frequency, in a specific frequency range or the like is occurring.


**Revendications**

1. Mécanisme de sécurité (9) destiné à un appareil d'éjection (8) devant être manipulé par une personne (30) préposée à la manoeuvre et faisant partie d'une installation d'éjection destinée à l'éjection d'agent sous pression, l'appareil d'éjection (8) destiné à être manipulé par un personne (30) préposée à la manoeuvre étant raccordé à une source d'abrasifs (3) par l'intermédiaire d'une canalisation d'alimentation (1) destinée à des abrasifs et présentant une poignée (17) destinée à être saisie ou enserrée par la main de la personne (30) préposée à la manoeuvre, le mécanisme de sécurité étant équipé d'un mécanisme de commande (10) destiné à la commande de la mise en service de l'appareil d'éjection (8), ainsi que d'un détecteur de mise en action (12) qui est disposé sur l'appareil d'éjection (8), qui doit être influencé par une personne (30) préposée à la manoeuvre et qui est raccordé au mécanisme de commande (10), le détecteur de mise en action (12) étant réalisé en forme de détecteur électronique de proximité, l'appareil d'éjection (8) étant automatiquement mis hors circuit lorsque le détecteur de mise en action (12) ne se trouve plus sous l'influence de la personne (30) préposée à la manoeuvre, **caractérisé en ce que** le détecteur de mise en action (12), à savoir, au moins un élément indicateur du détecteur de mise en action (12), est disposé sur la main de la personne (30) préposée à la manoeuvre.

2. Mécanisme de sécurité selon la revendication 1, **caractérisé en ce que** le détecteur de mise en action (12), à savoir, au moins un élément indicateur du détecteur de mise en action (12), est intégré à un gant de protection (32) destiné à la main de la personne (30) préposée à la manoeuvre.-

3. Mécanisme de sécurité selon la revendication 2, **caractérisé en ce que,** comme élément indicateur du détecteur de mise en action (12), une boucle d'indication ou une bobine sans fer (33) est insérée dans la surface de préhension du gant de protection (32).

4. Mécanisme se sécurité selon la revendication 2 ou 3, **caractérisé en ce que** l'élément indicateur est disposé au sein de la surface de préhension du gant de protection (32) à un endroit essentiellement immobile, en particulier, entre le pouce et l'index.

5. Mécanisme de sécurité selon l'une quelconque des revendications 1 à 4, dans lequel le détecteur de mise en action (12) est réalisé en forme de détecteur de proximité pouvant être influencé sans contact uniquement par un seul élément spécifique d'influence, en particulier, une feuille mince, de préférence, constituée d'aluminium, de cuivre, d'un matériau magnétique doux, présentant une perméabilité initiale élevée, tel que le mumétal ou analogues, **caractérisé en ce que** l'élément d'influence destiné au détecteur de mise en action (12) est disposé sur l'appareil (8) et est intégré, en particulier, en nappe à la surface de l'appareil (8).

6. Mécanisme de sécurité selon la revendication 5, **caractérisé en ce que** l'élément d'influence est intégré à la poignée (17), de préférence, sur la surface de préhension de la poignée (17).

7.  Mécanisme de sécurité selon l'une quelconque des revendications 1 à 4, **caractérisé en ce que** le détecteur de mise en action est réalisé sous forme de capteur acoustique, de préférence, sous forme de capteur de bruits d'impact, en particulier, sous forme de microphone pour bruits d'impact.

8.  Mécanisme de sécurité selon la revendication 7, **caractérisé en ce que** le mécanisme de commande présente au moins un filtre de fréquence attribué au capteur acoustique, en particulier, au microphone pour bruits d'impact.

9.  Mécanisme se sécurité selon la revendication 7 ou 8, **caractérisé en ce que** le mécanisme de commande présente un interrupteur de pontage et **en ce que,** lors de la mise en service de l'appareil devant être manipulé par la personne préposée à la manoeuvre du détecteur de mise en action, peut être ponté jusqu'à l'apparition d'un son, de préférence, d'un bruit d'impact à fréquence déterminée, faisant partie d'une gamme de fréquence déterminée ou analogues.

**Fig. 1**

EP 0 268 244 B1

# Fig. 2